# EUROPEAN PATENT APPLICATION

(11) **EP 2 386 842 A1**
(43) Date of publication of application: **16.11.2011**
(21) Application number: 10171390.7
(22) Date of filing: 30.07.2010
(51) Int. Cl.: G01J 5/08, G01J 5/20, H01L 31/0232, H04N 13/00, G01J 1/06

(54) **IR receiver, and liquid crystal shutter glasses having the same**

(30) Priority: 13.05.2010 KR 20100044877
(71) Applicant: Sekonix Co., Ltd., Dongducheon-si, Gyeonggi-do 483-100 (KR)
(72) Inventor: Choi, Mu-Gile, Seoul 132-044 (KR); Kim, Jin-Ho, Seoul 132-044 (KR); Seo, Dong-Jin, Seoul 132-044 (KR); Oh, Jin-Taek, Geyeonggi-do 483-100 (KR)
(74) Representative: Baronetzky, Klaus

(57) **Abstract**

There are provided an IR receiver and liquid crystal shutter glasses with the same, and more particularly, an IR receiver and liquid crystal shutter glasses having the same to solve the problem in that a pair of the crystal liquid shutter glasses malfunctions by infrared generated from the surrounding environment, such as a halogen light.

The liquid crystal shutter glasses comprises: an IR receiver including an IR sensor to receive an IR signal transmitted from a display device; two lenses of a right eye lens and a left eye lens having their respective liquid crystal shutters; and a liquid crystal driving unit to open and close the liquid crystal shutters of the two lenses, wherein the IR receiver comprises: an IR lens unit being convex toward the IR sensor; and an IR absorber to absorb the IR entering at a predetermined height/angle or more, among the incidence of the IR toward the IR sensor.

## Description

### CROSS-REFERENCE TO RELATED APPLICATION

This application claims the benefit of Korean Patent Application No. 2010-0044877, filed on May 13, 2010, the disclosure of which is hereby incorporated herein by reference in its entirety.

### BACKGROUND OF THE INVENTION

### 1. Field of the Invention

The present invention relates to an IR receiver and liquid crystal shutter glasses with the same, and more particularly, to an IR receiver and liquid crystal shutter glasses having the same to solve a problem in that the crystal liquid shutter glasses are malfunctioned by infrared light generated from the surrounding environment, such as a halogen light.

### 2. Description of the Related Art

A 3D television providing a user with a 3D image in television is actively developed. Methods to realize a stereoscopic 3D image effect are largely classified into one with special glasses and the other without special glasses. Specially, when a user uses special glasses, the stereoscopic 3D image effect is realized without additionally changing a panel for a television currently manufactured and therefore there are many further merits.

Types of the special glasses for the 3D image effect include a anaglyph type using anaglyph glasses with one blue lens for one eye and the other red lens for the other eye, a polarized type using polarized glasses with each lens having a different polarization direction, and a liquid crystal shatter type (or time multiplexing shutter type) using glasses with a liquid crystal shutter.

The method of realizing a 3D image effect by the liquid crystal shutter type will be described below:

When a 3D image is realized by the liquid crystal shutter type, a display device fast and alternately displays one image for a right eye and the other image for a left eye on a screen. To realize images in 3D, the liquid crystal shutter glasses open only the glass for the right eye regarding the image for the right eye and only the glass for the left eye regarding the image for the left eye, so that the 3D images are realized by using a time difference between the two eyes.

That is, it is essential for the 3D display device using the liquid crystal shutter type fast to display the image intended for the right eye and the image intended for the left eye and to synchronize opening of the glass for one eye with closing of the glass of the other eye of the liquid crystal shutter glasses, according to the timing of alternating the different images for each eye. As a synchronization method, for example, the liquid crystal shutter is synchronized with an IR signal transmitted from a display device. At present, this method is generally used, considering costs.

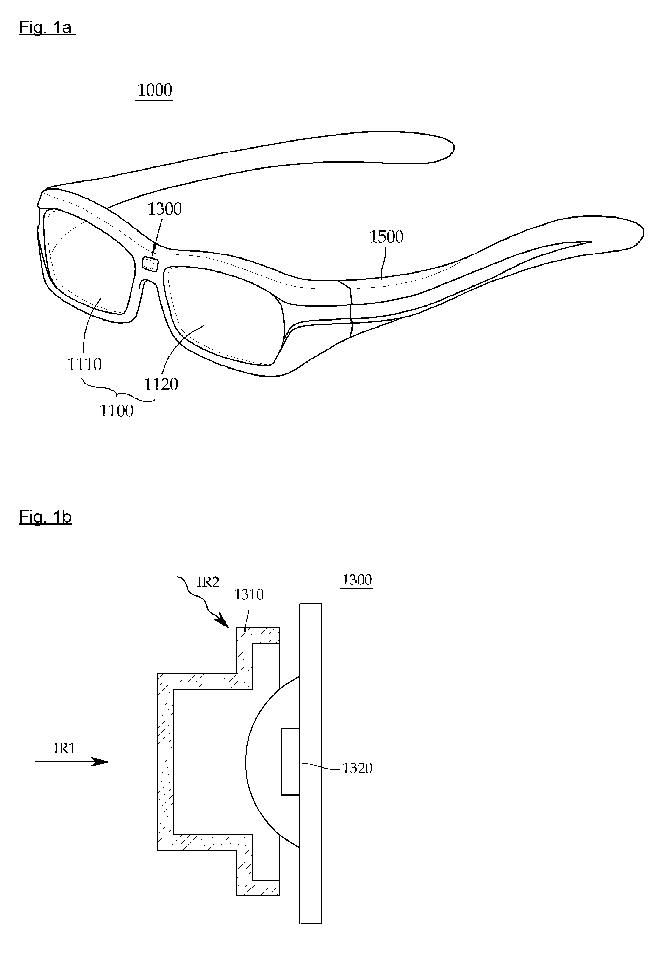

FIGS. 1a and 1b illustrate an example of a pair of conventional liquid crystal shutter glasses 1000.

As illustrated in FIG. 1a, the conventional liquid crystal shutter glasses comprises two lenses 1100 of a right eye lens 1110 and a left eye lens 1120, an IR receiver 1300 and a power supply unit 1500. Each of the right eye lens 1100 and the left eye lens 1120 comprises a liquid crystal shutter.

To produce a 3-D image effect by using the liquid crystal shutter glasses, a display device fast and alternately displays an image intended for the right eye and an image intended for the left eye on a screen. The liquid crystal shutter glasses allows only the right eye lens to be open with respect to the image intended for the right eye which is output from the display device and it allows only the left eye lens to be open with respect to the image intended for the left eye.

To synchronize the liquid crystal shutter glasses with the display screen, the liquid crystal shutter glasses synchronize the liquid crystal shutters with the IR signal being output from the display device.

For the synchronization with the IR signal, the liquid crystal shutter glasses specially include the IR receiver 1300. The IR receiver 1300 receives an infrared type synchronization signal transmitted from the display device (not shown). According to the received synchronization signal, a shutter signal driving unit (not shown) applies power to be on/off in the liquid crystal of each of the right eye lens 1110 and left eye lens 1120, so that the liquid crystals of the right eye lens 1110 and left eye lens 1120 are open and closed. Therefore, the 3D image is realized based on the time difference between the both eyes.

FIG. 1b more specifically illustrates the IR receiver 1300 of the conventional liquid crystal shutter glasses 1000.

As illustrated in FIG. 1b, the conventional IR receiver 1300 comprises an IR sensor 1320 and an IR sensor cover 1310 to protect the IR sensor 1310. The IR receiver 1300 in this structure is operated by receiving a synchronization signal IR1 transmitted from the display device (not shown) positioned in front of a user. Thus, when there is no IR signal interference from an indoor environmental light in the place where the display device is installed, the aforementioned structure has the advantage of performing relatively correct IR synchronization in comparison with costs.

However, when a halogen light is used as indoor illumination, a great quantity of infrared IR2 is emitted above by the emission of halogen. Thus, when the halogen light is used, the infrared IR2 emitted from the halogen light enters the IR sensor 1320, affecting the synchronization of the IR1 signal transmitted from the display device and the opening and closing the liquid crystals of the liquid crystal shutter glasses and therefore interrupting the normal operation of the liquid crystal shutter glasses.

Therefore, the IR receiver needs to prevent the received IR from being interrupted by an IR emitter in an external environment, such as the halogen light. Specially, it is more important to solve the aforementioned problem in the application of the liquid crystal shutter glasses requiring for high synchronization accuracy.

### SUMMARY OF THE INVENTION

Therefore, it is an object of the present invention to provide an IR receiver structured to solve the aforementioned problem caused by infrared radiation from an indoor halogen light, and a pair of liquid crystal shutter glasses with the IR receiver.

In accordance with an aspect of the present invention, there is provided a pair of liquid crystal shutter glasses comprising: an IR receiver with an IR sensor to receive an IR signal transmitted from a display device; two lenses of a right eye lens and a left eye lens each including a liquid crystal shutter; and a liquid crystal shutter driving unit to open and close the liquid crystal shutters of the two lenses, wherein the IR receiver comprises: an IR lens unit being convex toward the IR sensor, and an IR absorber to absorb IR entering at a predetermined height/angle or more, among the incidence of the IR toward the IR sensor.

In accordance with another aspect of the present invention, there is provided an IR receiver including an IR sensor to receive an IR signal, the IR receiver comprising an IR lens unit being convex toward the IR sensor; and an IR absorber to absorb IR entering at a predetermined height/angle or more, among the incidence of the IR toward the IR sensor.

Further, in the liquid crystal shutter glasses, a condensing lens unit may be formed of a convex lens being convex toward the IR sensor, so that even though a user of the liquid crystal shutter glasses does not locate within the range of a center part of a display screen, the IR synchronization of the liquid crystal shutter classes with the IR signal is more accurately performed.

Further, the condensing lens unit may be formed of the Fresnel lens to concentrate the IR to the IR sensor. When using the Fresnel lens for a condensing lens, a size, specifically, thickness, of the IR receiver is thin, improving the appearance of the liquid crystal shutter glasses.

Further, the IR receiver may further comprise a second IR absorber to the IR entering at a predetermined height/angle or less, among the incidence of the IR toward the IR sensor, the second IR absorber connected to a lower part of the condensing lens unit, thereby preventing the incidence of IR from an illuminator onto the IR receiver through the diffused reflection of a floor or the like.

Further, the IR absorber may be positioned, along an inside or outside circumference of the condensing lens.

### BRIEF DESCRIPTION OF THE DRAWINGS

The above and other features and advantages of the present invention will become more apparent to those of ordinary skill in the art by describing in detail preferred embodiments thereof with reference to the attached drawings in which:
FIG. 1a is a schematic view illustrating the structure of a pair of conventional liquid crystal shutter glasses;
FIG. 1b is a specific view of the constitution of an IR receiver in the glasses of FIG. 1a;
FIG. 2a is a schematic view illustrating the structure of a pair of liquid crystal shutter glasses according to the present invention;
FIG. 2b is a specific view of the constitution of an IR receiver in the glasses of FIG. 2a;
FIG. 3 is a schematic view of a range or angle of receiving IR in each of the glasses with and without a lens unit;
FIG. 4 is a modified example of a lens cover unit according to the present invention; and
FIG. 5 is another modified example of the lens cover unit according to the present invention.

### DETAILED DESCRIPTION OF THE PREFERRED EMBODIMENT

The present invention will now be described more fully hereinafter with reference to the accompanying drawings, in which preferred embodiments of the invention are shown so that those of ordinary skill in the art can easily carry out the present invention.

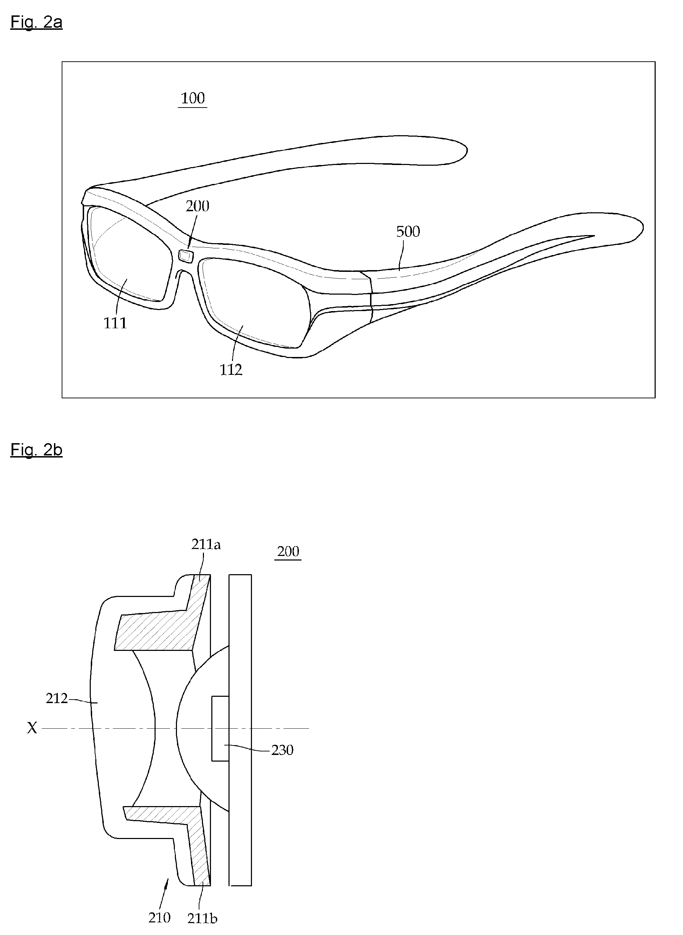

FIG. 2a schematically illustrates a pair of liquid crystal shutter glasses 100 according to the present invention.

As illustrated in FIG. 2a, the pair of the liquid crystal shutter glasses 100 comprises: two lenses 110 of a right eye lens 111 and a left eye lens 112; an IR receiver 200, and a power supply unit 500. The right eye lens 110 and the left eye lens 111 of the two lenses 110 include liquid crystal shutters, respectively.

FIG. 2b illustrates, in detail, the IR receiver 200 of the liquid crystal shutter glasses 100. As illustrated in FIG. 2b, the IR receiver 200 comprises: an IR sensor 230 to receive an IR signal transmitted from a display device (not shown); and a lens cover unit 210 to enclose the IR sensor 230.

The lens cover unit 210 comprises a lens unit 212 and an IR absorber 211 and it is formed by double injection. In this embodiment, the IR absorber 211 is positioned at an inside of the lens unit 212. Specifically, a first IR absorber 211 a is formed by a PC(BK) or the like, to absorb the infrared transmitted at a predetermined angle or more, based on an upper part on the center axis X of the IR sensor 230. In addition, a second IR absorber 211 b is formed by the PC(BK) or the like, to absorb the infrared transmitted at the predetermined angle or less, based on a lower part on the center axis X of the IR sensor 230.

In this embodiment, the IR absorbers 211 are positioned at the upper and lower parts in the inside circumference of the lens unit 212. However, the IR absorber 211 may include only the first IR absorber 211 a positioned at the upper part, considering that a halogen light is installed above.

Further, unlike the conventional cover 1310, the lens cover unit 210 according to this embodiment is structured to include the lens unit 212 being made of an IR resin and having its center part (i.e., a part of the cover 210 facing the IR sensor 230 in position) shaped to be convex toward the IR sensor 230.

The IR resin blocks visible light and allows only infrared light to pass, thereby preventing in advance the generation of a noise by the visible light. Further, as the lens unit 212 has the light converging characteristic in a downwardly convex shape toward the IR sensor 230, an angle of receiving the IR signal transmitted from the display device increases from θ1 in the conventional art to θ2. Therefore, the receiving characteristic of the IR sensor at the point which is not in the vertical direction of the display device is improved.

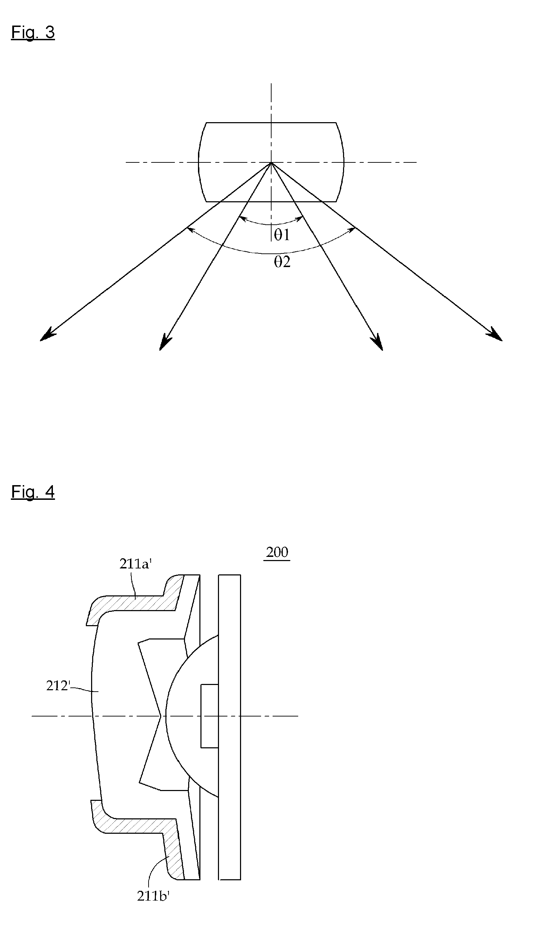

FIG. 4 illustrates a modified example of the lens cover unit according to the present invention.

The lens cover unit according to the modified embodiment illustrated in FIG. 4 is similar to the lens cover unit 210 illustrated in FIG. 2b, except for the IR absorbers 211'a and 211'b positioned at an upper part and a lower part of the outside of the IR lens unit 212 not the inside thereof. In this modified example, the IR absorber may include only the first IR absorber 211'a positioned at the upper part.

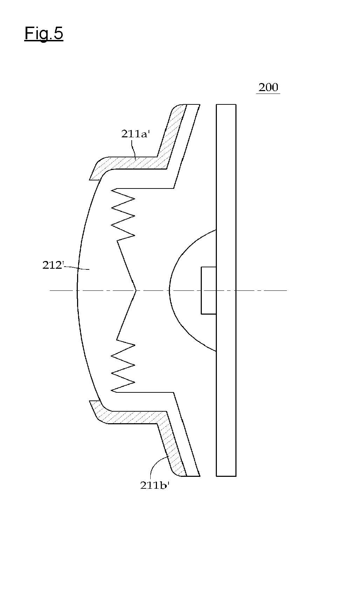

FIG. 5 illustrates another modified example of the lens cover unit according to the present invention.

The lens cover unit according to the modified embodiment illustrated in FIG. 5 is similar to the lens cover unit illustrated in FIG. 4, except for the point that the IR lens unit 212' is formed of the Fresnel lens 212'. In this case, the IR absorber may include only the first IR absorber 211'a positioned at the upper part. In this structure, since the Fresnel lens 212' is used instead of convex lens 212 in the aforementioned embodiments, there is the advantage in that the lens is manufactured so as to be thinner in thickness, compared with the existing convergent lens being convex toward the IR sensor.

In the foregoing, the structure of the IR receiver according to the present invention is used to the liquid crystal shutter glasses. However, the use of the structure of the IR receiver according to the present invention is not limited to the liquid crystal shutter glasses, and it is applicable to all electronic devices performing infrared communication, for example, a wireless remote controller or the like.

Further, in the above-described embodiments, the lens unit or the lens cover unit is formed of, preferably, an aspheric lens. However, the present invention does not limit thereto. It is obvious to any person skilled in the art that any lens having the structure to concentrate light to the IR sensor positioned under the lens unit can be used.

In accordance with the present invention, infrared emitted from the indoor halogen light is prevented from entering into the IR sensor by the IR absorber positioned at the upper part of the IR receiver of the liquid crystal shutter glasses. Therefore, when the IR receiver structure according to the present invention is applied to the liquid crystal shutter glasses, the infrared synchronization of the liquid crystal shutter glasses with the display device is stably realized under the halogen light.

The invention has been described using preferred exemplary embodiments. However, it is to be understood that the scope of the invention is not limited to the disclosed embodiments. On the contrary, the scope of the invention is intended to include various modifications and alternative arrangements within the capabilities of persons skilled in the art using presently known or future technologies and equivalents. The scope of the claims, therefore, should be accorded the broadest interpretation so as to encompass all such modifications and similar arrangements.

## Claims

1. An IR receiver including an IR sensor to receive an IR signal, the IR receiver comprising:
a condensing lens unit to concentrate IR from the outside to the IR sensor; and
an IR absorber connected to at least a part of the condensing lens unit, to absorb the IR entering at a predetermined angle, among the incidence of the IR toward the IR sensor.

2. Liquid crystal shutter glasses comprising:
an IR receiver including an IR sensor to receive an IR signal transmitted from a display device;
two lenses of a right eye lens and a left eye lens having their respective liquid crystal shutters; and
a liquid crystal driving unit to open and close the liquid crystal shutters of the two lenses,
wherein the IR receiver comprises:
an condensing lens unit to concentrate infrared (IR) to the IR sensor; and
an IR absorber connected to an upper part of the condensing lens unit, to absorb the IR entering at a predetermined height/angle or more, among the incidence of the IR toward the IR sensor.

3. The liquid crystal shutter glasses according to claim 2, wherein the condensing lens unit is formed of a convex lens being convex toward the IR sensor.

4. The liquid crystal shutter glasses according to claim 2, wherein the condensing lens unit is formed of the Fresnel lens to concentrate the IR to the IR sensor.

5. The liquid crystal shutter glasses according to claim 2, wherein the IR receiver further comprises: a second IR absorber connected to a lower part of the condensing lens unit, to absorb the IR entering at a predetermined height/angle or less, among the incidence of the IR toward the IR sensor.

6. The liquid crystal shutter glasses according to claim 2, wherein the IR absorber is positioned, along an outside circumference of the condensing lens.

7. The liquid crystal shutter glasses according to claim 2, wherein the IR absorber is positioned, along an inside circumference of the condensing lens.

8. The liquid crystal shutter glasses according to one of the claims 2 to 7, **characterized in that** the IR absorber comprises an essentially cylindrical portion and an essentially frusto-conical portion (211'a, 211'b) which extends from the essentially cylindrical portion towards a base on which the IR sensor (210) is mounted in an oblique manner.

9. The liquid crystal shutter glasses according to one of the claims 2 to 8, **characterized in that** said IR lens unit is held and supported on a base for mounting the IR sensor (230).

10. The liquid crystal shutter glasses according to one of the claims 2 to 9, **characterized in that** said lens unit is mounted on or at a lens unit supporting structure, preferably in a one piece arrangement, and that said IR absorber covers at least outer areas of said lens supporting structure distal from an optical center axis (X) of said IR sensor (230).

11. The liquid crystal shutter glasses according to claims 2 to 10, **characterized in that** said IR absorber allows an aperture of the condensing lens unit with an aperture angle of more than 20° and less than 60°, preferably about 45°, referred to the optical center axis (X) of the IR sensor (230).
